Europäisches Patentamt

**European Patent Office**

**Office européen des brevets**

(11) Publication number: **0 086 724**
A2

## (12) EUROPEAN PATENT APPLICATION

(21) Application number: **83400316.2**

(22) Date of filing: **15.02.83**

(51) Int. Cl.³: **H 01 L 23/48**

(30) Priority: **16.02.82 US 349137**

(43) Date of publication of application: **24.08.83**
Bulletin 83/34

(84) Designated Contracting States: **DE FR GB IT NL**

(71) Applicant: **FAIRCHILD CAMERA & INSTRUMENT CORPORATION, 464 Ellis Street, Mountain View California 94042 (US)**

(72) Inventor: **Phy, William S., 25616 Moody Road, Loas Altos Hills, CA 94022 (US)**

(74) Representative: **Chareyron, Lucien et al, Schlumberger Limited 42, rue Saint-Dominique, F-75340 Paris Cedex 07 (FR)**

(54) Integrated circuit lead frame with improved power dissipation.

(57) A lead frame apparatus for providing electrical connections to an integrated circuit includes a paddle 10 to which the integrated circuit is attached, a series of electrically conductive leads 12 extending outward from opposite sides of the paddle 10, and flared regions 18 of generally expanding width extending outward from opposite sides of the paddle 10. In the preferred embodiment the flared region 18 and the electrically conductive leads 12 are maintained in alignment by tie and dam bars 15 and 17 which are removed after the lead frame 5 is encapsulated.

## INTEGRATED CIRCUIT LEAD FRAME
## WITH IMPROVED POWER DISSIPATION

### Background of the Invention

#### Field of the Invention

This invention relates to lead frames for use in packaging and making electrical connections with integrated circuits. In particular, this invention relates to a lead frame capable of dissipating power more efficiently.

#### Description of the Prior Art

Integrated circuits may be manufactured and packaged using a variety of techniques. One well-known technique for packaging integrated circuits is the dual-in-line package, commonly known as a DIP. Dual-in-line packages may be fabricated using a variety of techniques. According to one technique a lead frame is fabricated from a sheet of electrically conductive material. The lead frame includes a "paddle," to which the integrated circuit die or chip is attached using known physical or chemical techniques, for example, metallurgical bonding. A series of leads extend from the proximity of the paddle to what will become the pins of the completed package. After the chip is bonded to the paddle, individual wires are electrically connected between the bonding pad on the chip and the leads. The leads, paddle, and pins are maintained in the correct alignment with respect to each other by paddle support, dam and tie bars, which are later removed.

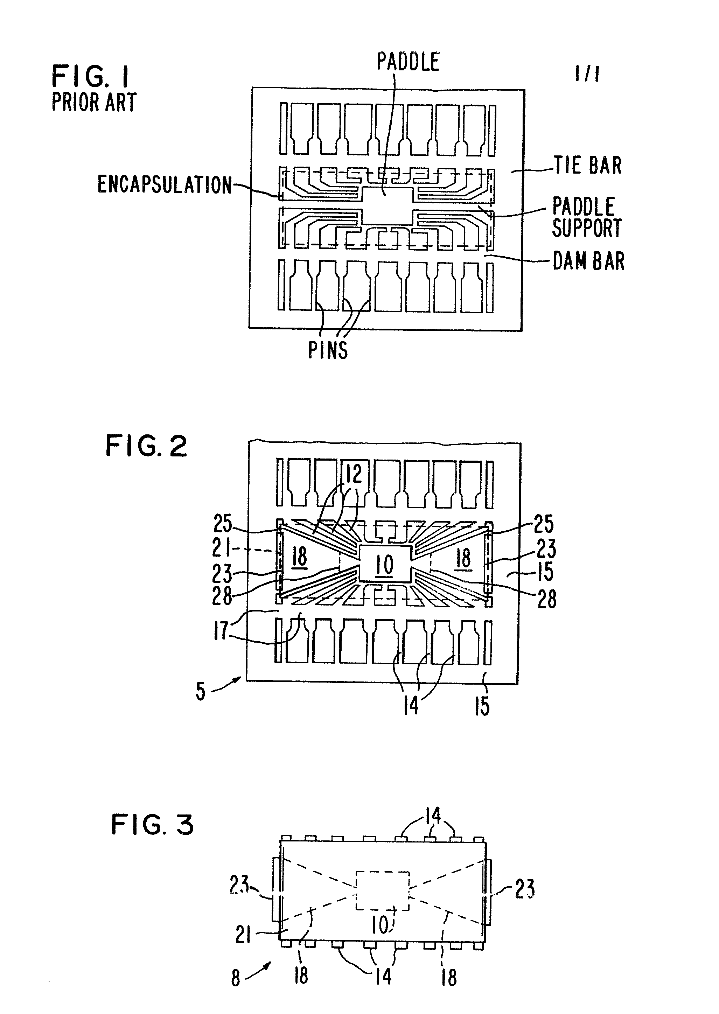

After the wire bonds are complete, the combined chip, wire bonds, and most of the lead frame are encapsulated in a plastic material such as epoxy. After encapsulation the dam and tie bars are broken away, for example, by a stamping operation. The package may then be de-flashed to remove any excess plastic present at the mold line. In typical prior art lead frames the paddle was held in alignment with the tie-bar by relatively small paddle support bars as shown in Figure 1.

As improvements in fabrication technology have allowed the formation of more and more active and/or passive components in a given integrated circuit, the need to dissipate heat from that circuit has become correspondingly greater. Plastic dual-in-line packages are not often selected for applications in which dissipation of large amounts of heat was desirable. The heat generated by the chip must be transferred out of the plastic package through the bonding wires, the metal lead frame and the plastic. Because the cross-sectional areas of the bonding wires and prior art paddle support bars are so small, the wires and bar have a high resistance to heat transfer, and therefore much of the heat must flow away from the chip through the paddle and then through the plastic to the surface of the package. Because the prior art forces much of the heat to flow through plastic such as epoxy, which has low thermal conductivity, rather than through metal such as copper, which has high thermal conductivity, the packages dissipate heat less effectively. It is the object of this invention to improve the heat dissipation characteristics of dual-in-line packages.

## Summary of the Invention

This invention provides a lead frame for use in the packaging of integrated circuits which conducts heat away from the integrated circuit at a substantially higher rate than previously available lead frames. In one embodiment the lead frame apparatus of this invention for providing electrical connections to an integrated circuit comprises a paddle region to which the integrated circuit is attached, a plurality of electrically conductive leads extending generally outward from opposite sides of the paddle region and to which plurality the integrated circuit is electrically connected, and at least one flared region of thermally conductive material coupled to the paddle at a first location of smaller width and extending outward to a second location of larger width. In the preferred embodiment the paddle region is substantially rectangular in plan form, the plurality of electrically conductive leads extend outward from two opposite sides, and the two flared regions extend generally outward from the remaining sides of the paddle to occupy substantially all of the space between the electrically conductive leads.

## Brief Description of the Drawings

Figure 1 is plan view of a prior art lead frame.

Figure 2 is a plan view of one embodiment of the lead frame of this invention.

Figure 3 is a view of one embodiment of the lead frame after encapsulation in a plastic package.

## Detailed Description of the Preferred Embodiments

Figure 1 is a plan view of a typical prior art lead frame structure in which the integrated circuit is bonded to a paddle, and electrical connections are made between the integrated circuit and the leads by well-known wire bonding or other techniques. After encapsulation of the integrated circuit, the paddle, and the leads in suitable material, typically plastic, the tie and dam bars which maintain the pins, leads, paddle, and paddle supports all in the proper alignment during the fabrication of electrical connections between the integrated circuit and the leads, and the encapsulation process, are removed. The pins are then bent downward into a suitable position to adapt them for subsequent insertion into a receiving socket.

Figure 2 is a plan view of one embodiment of an improved lead frame fabricated according to this invention. As shown in Figure 2, the improved lead frame includes a paddle 10, a plurality of conductive leads 12, each having associated therewith one of a series of conductive pins 14. The pins are maintained in alignment by a tie bar 15 which forms the periphery of the lead frame 5. The proper alignment of the pins 14 and conductive leads 12 with respect to the paddle 10 is maintained by the dam bar 17 and tie bar 15. The paddle 10 is maintained in proper alignment with conductive leads 12 by paddle supports 18. A dashed line 21 indicates the periphery of the plastic encapsulation formed around the integrated circuit mounted on paddle 10, the conductive leads 12, and the paddle support 18. The integrated circuit may be attached to the paddle 10 using epoxy, a polyimide, eutectic bonding, or other known processes.

The paddle support regions 18 shown in Figure 2 are substantially larger than those of the prior art. This enables substantially more heat to be conducted from the paddle to the exterior of the package. As shown in Figure 2, a small portion 23 of one or both paddle support 18 may be allowed to project beyond the the encapsulation 21 to further increase the heat dissipation characteristics of the package. To prevent an increase in the shear forces required to separate the molded package from the tie-bar, the paddle support 18 may be connected to the tie bar 15 using small connecting regions 25. In the preferred embodiment the small connecting regions 25 will have a combined width similar to that of the prior art paddle support bar (shown in Figure 1) to enable use of the same manufacturing equipment with the lead frame 5 shown in Figure 2 as with the prior art lead frame shown in Figure 1. Furthermore, because the small connecting regions 25 are relatively widely spaced from each other, the certainty of correct paddle 10 alignment with respect to the conducting leads 12 is increased over prior art structures.

In the manner described, the preferred embodiment of this invention provides enhanced power dissipation for an integrated circuit without the addition of other radiating members frequently used. By fabricating a lead frame in accordance with this invention, a thermal path for dissipation of heat from the integrated circuit is provided in a manner which has been virtually ignored in prior art plastic packaging.

In certain prior art lead frames, the paddle is vertically displaced from the plane of the remainder of the lead frame to provide improved clearance between the conductive leads and the paddle. This technique may be employed in conjunction with the structure depicted in Figure 2 by displacing the paddle 10 downward approximately the thickness of the lead frame by bending at dashed lines 28. With this configuration, the adjacent leads 12 are not electrically coupled by this paddle support 18 when the paddle support 18 is formed from substantially all the material between the adjacent leads. Thus, the paddle support 18 can be wider than prior art paddle support bars without electrically shorting the adjacent leads, thereby reducing the paddle support's thermal resistance. This configuration allows more heat to be dissipated through the paddle support bar.

Figure 3 is a top view of the completed integrated circuit package 8. The paddle 10 and paddle supports 18 are shown in dashed lines. A portion 23 of the paddle support 18 projects from each end of the plastic encapsulation 21. The pins 14 are bent downward, and the dam bar 17 separating adjacent pins has been removed.

Although several embodiments of the improved lead frame of this invention have been described above, these embodiments are intended to illustrate the invention rather than limit it. In particular, the structure of the lead frame 5 may be adapted as necessary to the integrated circuit attached to paddle 10. For example, greater or lesser numbers of conductive leads may be provided depending upon the circuit to which connections are made. The scope of the invention may be ascertained from the appended claims.

0086724

## CLAIMS

1. A lead frame apparatus for providing electrical connections to an integrated circuit comprising:

a paddle region (10) to which the integrated circuit is attached;

a plurality of electrically conductive leads (12) extending generally outward from opposite sides of the integrated circuit, characterized by

at least one region (18) of thermally conductive material coupled to the paddle (10) at a first location of smaller width and extending outward to a second location (23) of larger width.

2. Apparatus as in claim 1 characterized in that at least one region (18) is disposed between two electrically conductive leads (12) and occupies substantially all of the area between those two leads.

3. Apparatus as in claim 2 characterized in that the paddle (10) is substantially rectangular in shape.

4. Apparatus as in claim 3 characterized in that the at least one region (18) comprises two regions oppositely disposed on opposite sides of the paddle region (10).

5. Apparatus as in claim 4 characterized in that the electrically conductive leads (12) are connected to pins (14) for insertion into a socket.

6. Apparatus as in claim 5 characterized in that the pins (14), the conductive leads (12), and the at least one region (18), are all connected to a surrounding tie bar (15) for maintaining alignment.

FIG. 1
PRIOR ART

PADDLE

ENCAPSULATION

TIE BAR

PADDLE
SUPPORT

DAM BAR

PINS

FIG. 2

12

25
21
23
28

18

10

18

25
23
15
28

17

5

14

15

FIG. 3

14

23

23

21

10

8

18

14

18